(19) Europäisches Patentamt
European Patent Office
Office européen des brevets

(11) EP 1 464 671 A1

(12) **EUROPEAN PATENT APPLICATION**
published in accordance with Art. 158(3) EPC

(43) Date of publication:
**06.10.2004 Bulletin 2004/41**

(21) Application number: **02790750.0**

(22) Date of filing: **13.12.2002**

(51) Int Cl.[7]: **C08L 27/12**

(86) International application number:
**PCT/JP2002/013047**

(87) International publication number:
**WO 2003/051987 (26.06.2003 Gazette 2003/26)**

(84) Designated Contracting States:
**AT BE BG CH CY CZ DE DK EE ES FI FR GB GR IE IT LI LU MC NL PT SE SI SK TR**

(30) Priority: **17.12.2001 JP 2001383060**

(71) Applicant: **Daikin Industries, Ltd.**
**Osaka-shi, Osaka 530-8323 (JP)**

(72) Inventors:
- **MORIKAWA, Tatsuya, c/o Yodogawa-seisakusho Settsu-shi, Osaka 566-8585 (JP)**
- **NISHIBAYASHI, Hirofumi, c/o Yodogawa-seisakusho Settsu-shi, Osaka 566-8585 (JP)**
- **HIGASHINO, Katsuhiko, c/o Yodogawa-seisakusho Settsu-shi, Osaka 566-8585 (JP)**
- **OGATA, Shintaro, c/o Yodogawa-seisakusho Settsu-shi, Osaka 566-8585 (JP)**
- **KAWASAKI, Kazuyoshi, c/o Yodogawa-seisakusho Settsu-shi, Osaka 566-8585 (JP)**
- **KISHINE, Mitsuru, c/o Yodogawa-seisakusho Settsu-shi, Osaka 566-8585 (JP)**

(74) Representative: **HOFFMANN EITLE**
**Patent- und Rechtsanwälte**
**Arabellastrasse 4**
**81925 München (DE)**

## (54) ELASTOMER FORMED PRODUCT

(57) The present invention provides a fluorine-containing elastomer molded article, which is capable of withstanding use in high temperatures of 275°C or higher and has resistance to high density plasma. Specifically, the present invention provides a fluorine-containing elastomer molded article obtained by crosslinking with a heat resistant crosslinking agent a crosslinkable fluorine-containing elastomer composition comprising an inorganic filler having a average primary particle size of at most 0.5 µm, such as α-type aluminum oxide and aluminum nitride, and a fluorine-containing elastomer component having a CN group or a COOH group, such as a perfluoro elastomer.

FIG. 1

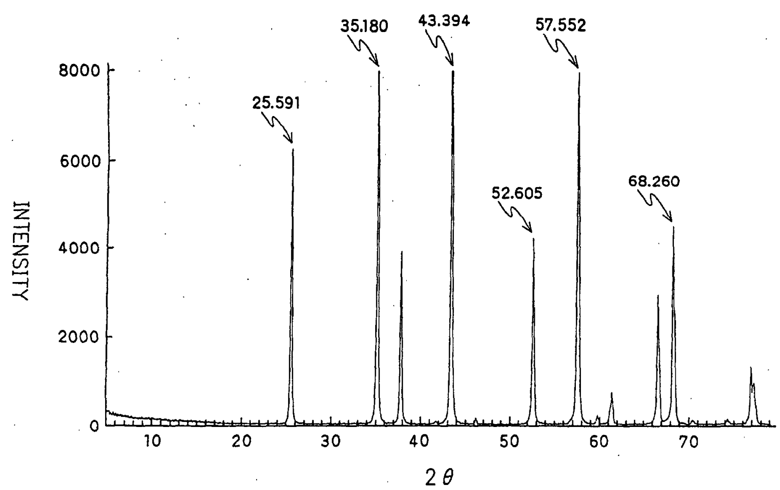


EP 1 464 671 A1

## Description

TECHNICAL FIELD

The present invention relates to a fluorine-containing elastomer molded article, which has favorable sealing properties while maintaining processability (mixing processability) and crosslinking properties, in which thermal degradation is inhibited under use in high temperatures of more than 275°C, particularly continuous use in high temperatures and temporary use in high temperatures, and which is excellent in high density plasma resistance.

BACKGROUND ART

In the field of semiconductor production, one of the most important requirements is to prevent fine particulate foreign substances referred to as particles from being mixed in the preparation process. This is also desired in sealing material such as an O-ring, which is used for sealing in semiconductor manufacturing equipment. Consequently, fine particle fillers are being considered, because when the filler that is compounded in the elastomer molded article that forms the sealing material is ultra-fine particles (average primary particle size 0.005 to 0.05 μm), the particles are smaller than the distance between the lines (usually at least 0.2 μm) of the micropattern that is formed on the semiconductor and therefore are not imbedded between the lines to cause wire connection, even when the filler flies out of the sealing material due treatment such as plasma irradiation.

In the field of semiconductor manufacturing equipment, aluminum oxide fillers are beginning to be employed (WO 01/32782) instead of the usual carbon black, as plasma resistance (the property of decrease in weight and generation of particles being small under plasma irradiation) is favorable.

Besides the above, recently, processability at high temperatures of 230 to 300°C is demanded in equipment used for manufacturing semiconductors. As an elastomer molded article that provides heat resistance under such high temperatures, suggested is a crosslinkable elastomer composition, wherein an inorganic filler, such as aluminum oxide surface-treated with a silane compound such as a silane coupling agent, is compounded (JP-A-2000-290454). According to this publication, molding processability is improved, but there are no descriptions regarding particle size or use. Also, the silane compound used for surface treatment is an impurity and ultimately becomes a cause of contamination.

JP-A-2000-502122 suggests a composition wherein titanium dioxide or aluminum oxide is the filler. However, the particle size of the filler that is used is not described and preventing generation of particles is not the object thereof. Also, because titanium dioxide is essential, there is the problem that decrease in weight of the molded article due to plasma irradiation is large.

Furthermore, WO 01/32782 describes a crosslinkable elastomer composition wherein a fine particle inorganic filler (average primary particle size approximately 0.005 to 0.05 μm) is compounded, but properties at 275°C or higher are not evaluated.

Usually, in a crosslinkable elastomer composition, the smaller the particle size of the compounded inorganic filler is the stronger the surface activity becomes and when used in high temperatures, the elastomer deteriorates. Therefore, the crosslinkable elastomer composition of WO 01/32782 starts to deteriorate in a high temperature environment of 275°C or higher and compression set becomes large, thereby decreasing sealing ability (see Com. Ex. 1 to 4 described below).

Also, JP-A-1-118560 describes compounding an aluminum oxide filler having an average particle size 0.1 to 10 μm in the elastomer. However, the crosslinking type is a peroxide crosslinking type wherein a crosslinking agent that does not have fluorine atoms (TAIC) is used for crosslinking the elastomer. Furthermore, obtaining heat resistance is not the object thereof and a heat resistant elastomer molded article is not obtained.

JP-A-2000-154369 describes a vulcanizing agent that improves heat resistance. However, although there is a general description regarding compounding a metal oxide filler having particle size of 0.1 to 30 μm, specifically, a metal oxide filler of at least 10 μm is used. Also, JP-A-2000-154369 does not describe that heat resistance of the elastomer molded article changes depending on the type of filler and does not suggest that heat resistance is excellent.

Furthermore, these publications do not disclose how an inorganic filler influences high-density plasma resistance or which filler provides an elastomer molded article that has both plasma resistance and heat resistance.

Kalrez 8475 and Kalrez 8575 (both trade names) available from DuPont Dow Elastomers Japan K.K. are known as a sealing material that is particularly excellent in heat resistance. However, the decrease in weight by $NF_3$ plasma irradiation under the severe plasma irradiation conditions of the present invention described below was 5.83 % by weight for Kalrez 8475 and 3.52 % by weight for Kalrez 8575 and do not satisfy the demand for higher plasma resistance.

The present invention aims to provide a molded article that does not thermally degrade by use in high temperatures and does not deteriorate by high-density plasma irradiation.

DISCLOSURE OF INVENTION

The present invention relates to a fluorine-containing elastomer molded article obtained by crosslinking a crosslinkable elastomer composition comprising 0.5 to 100 parts by weight of an inorganic filler having a average primary particle size of at most 5 μm, based on 100 parts by weight of a fluorine-containing elastomer component; wherein the compression set the fluorine-containing elastomer molded article under the following conditions (1) is at most 50 %, more preferably at most 40 %, further preferably at most 30 %, and the decrease in weight by $NF_3$ plasma irradiation of the fluorine-containing elastomer molded article under the following conditions (2) is at most 3 %, preferably at most 2 %.

Conditions (1)

Sample: O-ring (AS-568A-214)

Measurement conditions: Compression set at 275°C after 70 hours is measured according to JIS K6262-1997

Conditions (2)

Sample: O-ring (AS-568A-214)

Measurement device: ICP high-density plasma device

This device takes on the following plasma parameter when the amount of $O_2$ gas is 16 SCCM, the RF output is 800 W and the pressure is 10 militorr.

(Plasma parameter)

Electron temperature Te: 4.54 eV
Electron density Ne: $5.81 \times 10^{10}$ $cm^{-3}$
Ion concentration Ni: $1.14 \times 10^{10}$ $cm^{-3}$
Saturated ion current Ii: 2.87 $mAcm^{-2}$
Plasma potential Vp: 27.76 V
Floating potential Vf: 11.42 V

Measurement conditions:

$NF_3$ flow rate: 16 SCCM
Pressure: 10 militorr
RF output: 800 W
Irradiation time: 30 minutes
Frequency: 13.56 MHz

The crosslinking type is preferably a heat resistant crosslinking type, excluding a peroxide crosslinking type wherein only a non-fluorine crosslinking agent is used.
The inorganic filler preferably contains at least one kind of inorganic filler containing aluminum, consists of an inorganic filler containing aluminum, contains at least one kind of inorganic filler essentially consisting of aluminum as a metal atom or consisits of an inorganic filler essentially consisting of aluminum as a metal atom.
The inorganic filler is preferably an aluminum oxide filler, an aluminum nitride filler or an aluminum fluoride filler.
A more preferable aluminum oxide filler is an aluminum oxide filler wherein six peaks (hereinafter referred to as major peaks) selected in order of strength that appear in a diffraction chart when measured by X-ray crystal structure diffraction are all peaks that are derived from α-type crystal structure of aluminum oxide, particularly an aluminum oxide filler wherein the peaks that appear in a diffraction chart when measured by X-ray crystal structure diffraction are essentially only peaks that are derived from α-type crystal structure of aluminum oxide.
The average primary particle size of the inorganic filler is preferably at most 1.0 μm, more preferably at most

0.2 µm.

The fluorine-containing elastomer is preferably a perfluoro elastomer having a crosslinkable group, particularly a perfluoro elastomer having a crosslinkable group containing a structural unit derived from perfluoro olefin having 2 to 3 carbon atoms, a structural unit derived from perfluoro(vinyl ether) and a structural unit derived from a monomer capable of forming a crosslinkable group.

The crosslinkable group of the fluorine-containing elastomer is preferably a CN group and/or a COOH group.

The crosslinking agent used for crosslinking the crosslinkable fluorine-containing elastomer is preferably a compound represented by formula (1):

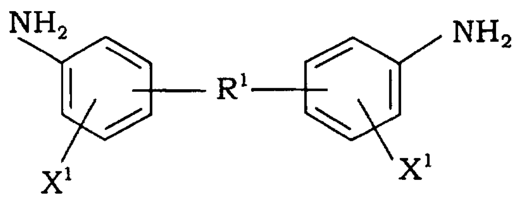

(wherein $R^1$ is $-SO_2-$, -O-, -C(=O)-,

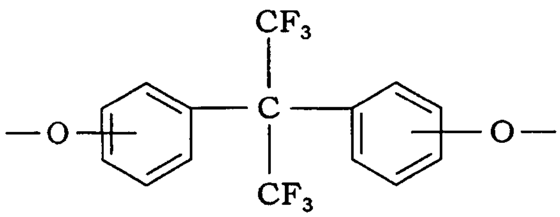

,

an alkylidene group having 1 to 10 carbon atoms, a perfluoroalkylidene group having 1 to 10 carbon atoms or a single bonding; $X^1$ is the same or different and is -OH, $-NH_2$, -SH, -NHR (R is a linear or branched alkyl group having 1 to 6 carbon atoms that can be substituted) or -NHAr (Ar is a phenyl group or a naphthyl group that can be substituted));

a compound represented by formula (2):

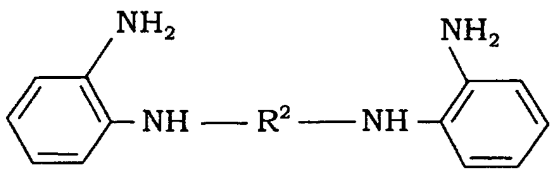

(wherein $R^2$ is a linear or branched alkylidene group that can be substituted, an arylene group that can be substituted,

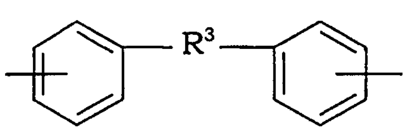

,

$R^3$ is $-SO_2-$, -O-, -C(=O)-,

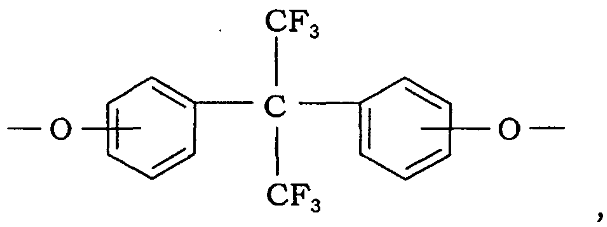

or a single bonding);
a compound represented by formula (3):

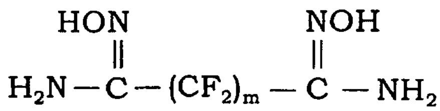

(wherein m is an integer of 1 to 10);
a compound represented by formula (4):

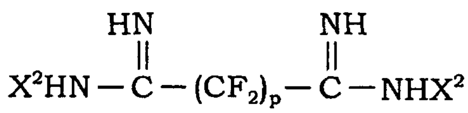

(wherein $X^2$ is the same or different and is H or $NH_2$; p is an integer of 1 to 10); and/or
a compound represented by formula (5):

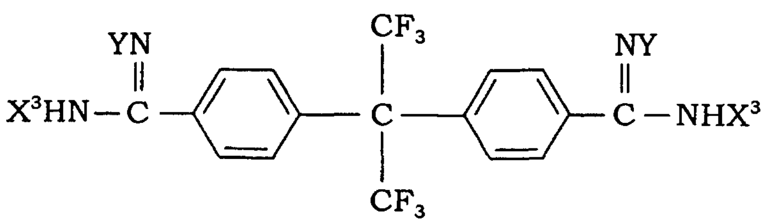

(wherein $X^3$ is the same or different and is H or $NH_2$; Y is the same or different and is H or OH).

Particularly, a compound wherein in formula (1), $R^1$ is

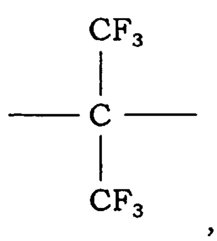

and $X^1$ is

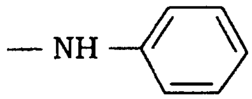

is preferable.

Also, an organic tin compound can be contained as a crosslinking accelerator.

The elastomer molded article of the present invention is particularly useful when used as sealing for semiconductor manufacturing equipment.

BRIEF DESCRIPTION OF DRAWINGS

Fig. 1 is the X-ray crystal structure diffraction chart of the aluminum oxide filler used in Example 1 and Comparative Example 6 of the present invention.
Fig. 2 is the X-ray crystal structure diffraction chart of the aluminum oxide filler used in Example 2 of the present invention.
Fig. 3 is the X-ray crystal structure diffraction chart of the aluminum oxide filler used in Example 3 of the present invention.
Fig. 4 is the X-ray crystal structure diffraction chart of the aluminum oxide filler used in Example 4 of the present invention.
Fig. 5 is the X-ray crystal structure diffraction chart of the aluminum oxide filler used in Comparative Example 1 of the present invention.
Fig. 6 is the X-ray crystal structure diffraction chart of the aluminum oxide filler used in Comparative Example 2 of the present invention.
Fig. 7 is the X-ray crystal structure diffraction chart of the aluminum oxide filler used in Comparative Example 3 of the present invention.
Fig. 8 is the X-ray crystal structure diffraction chart of the aluminum oxide filler used in Comparative Example 4 of the present invention.
Fig. 9 is the X-ray crystal structure diffraction chart of the aluminum oxide filler used in Comparative Example 5 of the present invention.

BEST MODE FOR CARRYING OUT THE INVENTION

The elastomer molded article of the present invention is obtained by crosslinking a crosslinkable fluorine-containing elastomer composition containing an inorganic filler having a specific average primary particle size and a fluorine-containing elastomer having a crosslinkable group in a specific ratio. The molded article is defined by the physical properties of compression set in a high temperature (275°C) of at most 50 % and decrease in weight by $NF_3$ plasma irradiation of at most 3 %.

Examples of the inorganic filler that is used are metal oxide fillers such as titanium dioxide, silicon oxide, aluminum oxide and zinc oxide; sulfate fillers such as barium sulfate and aluminum sulfate; carbonate fillers such as barium carbonate; metal hydroxide fillers such as aluminum hydroxide; nitride fillers such as aluminum nitride and silicon nitride; fluoride fillers such as aluminum fluoride and calcium fluoride; silicate fillers such as aluminum silicate and calcium silicate; phosphate fillers such as calcium phosphate and aluminum phosphate; borate fillers such as aluminum borate and carbide fillers such as silicon carbide, aluminum carbide and calcium carbide. Of these, from the viewpoint that high-density plasma resistance is excellent, an inorganic filler containing only aluminum as the metal atom is preferable. Examples of the inorganic filler containing only aluminum as the metal atom are aluminum trihydride, aluminum oxide, aluminum sulfide, aluminum sulfite, aluminum sulfate, aluminum dithionate, aluminum sulfamate, aluminum selenide, aluminum selenite, aluminum selenate, aluminum telluride, aluminum tellurite, aluminum tellurate, aluminum fluoride, aluminum chloride, aluminum chlorate, aluminum perchlorate, aluminum iodide, aluminum nitride, aluminum nitrate, aluminum phosphide, aluminum dihydrogenhypophosphite, aluminum hydrogenphosphite, aluminum hypophosphate, aluminum orthophosphate, aluminum hydrogenphosphate, aluminum trihydrogenphosphate, aluminum pyrophosphate, aluminum hydrogenpyrophosphate, aluminum metaphosphate, aluminum thiophosphite, aluminum thiohypophosphate, aluminum arsenide, aluminum arsenite, aluminum orthoarsenate, aluminum pyroarsenate,

aluminum ammonium hexafluoride, aluminum ammonium sulfate, aluminum ammonium selenate, aluminum hydrazinium sulfate, aluminum hydrazinium fluoride and hydrates thereof. As long as the effects of the present invention are not lost, two or more of these inorganic fillers can be used together, at least one inorganic filler that does not contain aluminum as a metal atom can be used together and at least one inorganic filler that contains aluminum and at least one other metal atom can be used together.

Also, as long as the effects of the present invention are not lost, an inorganic filler containing aluminum and at least one other metal atom can be used. Examples of the inorganic filler containing aluminum and at least one other metal atom are aluminum antimonide, aluminum bismuthate, aluminum bismuth bromide, lithium aluminum hydride, lithium aluminate, lithium hydrogenaluminate, lithium aluminum nitride, trilithium aluminum hexafluoride, sodium aluminum hydride, sodium aluminate, sodium aluminum amide, trisodium aluminum hexafluoride, sodium aluminum chloride, aluminum sodium sulfate, potassium aluminate, aluminum potassium amide, tripotassium aluminum hexafluoride, potassium aluminum chloride, potassium aluminum sulfate, potassium aluminum selenate, rubidium aluminum sulfate, rubidium aluminum hexafluoride, cesium aluminum hexafluoride, copper aluminum sulfate, silver aluminum sulfate, beryllium aluminate, magnesium aluminum hydride, magnesium aluminate, magnesium aluminum sulfate, calcium aluminate, strontium aluminate, barium aluminate, zinc aluminate, zinc aluminum sulfate, cadmium aluminate, zeolite and hydrates thereof.

As long as the effects of the present invention are not lost, two or more of these inorganic fillers can be used together and at least one inorganic filler that does not contain aluminum can be used together.

Generally, fine particle inorganic fillers have higher surface activity, such as various catalyst activity and adsorption activity, than particles of a large particle size, as a result of being fine particles, and are considered to impair heat resistance of and modify the elastomer by becoming fine particles. Indeed, this phenomenon occurs in many inorganic fillers. However, the present inventors have surprisingly found that the deterioration phenomenon caused by surface activity does not occur in an aluminum oxide filler, particularly an aluminum oxide filler wherein the major peaks that appear in a diffraction chart when measured by X-ray crystal structure diffraction are all peaks that are derived from $\alpha$-type crystal structure of aluminum oxide. Examples of the crystal type of aluminum oxide are $\alpha$-type, $\gamma$-type, $\delta$-type and $\theta$-type, but this phenomenon can only be seen in $\alpha$-type.

This unique phenomenon appears particularly noticeably in an aluminum oxide filler wherein the peaks that appear in the diffraction chart when measured by X-ray crystal structure diffraction are essentially all peaks that are derived from $\alpha$-type crystal structure of aluminum oxide. Herein, "essentially all peaks that are derived from $\alpha$-type crystal structure of aluminum oxide" means that clear peaks derived from other crystal types of aluminum oxide are not observed.

The peaks derived from $\alpha$-type crystal structure of aluminum oxide that appear in a diffraction chart when measured by X-ray crystal structure diffraction are observed in a sharp form as the major peaks at diffraction angle of 35°, 43° and 57° and smaller peaks at diffraction angle of 25°, 37°, 52°, 66° and 68° are also observed (Figs. 1, 2 and 9 described below). Examples wherein the "major peaks" are $\alpha$-type crystal are Figs. 3 and 4 described below. On the other hand, the peaks of other crystal types are small and broad (Figs. 5 to 8 described below) and can be clearly differentiated from those of $\alpha$-type.

Also, the present inventors have found that the deterioration phenomenon caused by surface activity does not occur in an aluminum nitride filler.

The primary particle size of the inorganic filler such as aluminum oxide is at most 5 $\mu$m, preferably at most 1.0 $\mu$m, more preferably at most 0.2 $\mu$m.

When using the filler for an elastomer molded article used for semiconductor manufacturing equipment, the particle size is preferably small from the viewpoint of keeping generation of particles low. The lower limit is in the range in which physical and chemical production and pulverization are possible and is usually approximately 0.001 $\mu$m.

The fluorine-containing elastomer, which is the elastomer component of the present invention, is preferably a perfluoro elastomer having a crosslinkable group. Particularly, preferable is a perfluoro elastomer containing a structural unit derived from perfluoro olefin having 2 to 3 carbon atoms, a structural unit derived from perfluoro(vinyl ether) and a structural unit derived from a monomer capable of giving a crosslinkable group, from the viewpoint that the mechanical strength of the molded article is excellent.

Examples of perfluoro olefin having 2 to 3 carbon atoms are tetrafluoroethylene (TFE) and hexafluoropropylene (HFP) and TFE is preferable from the viewpoint that flexibility is high in low temperatures. Also, HFP can be copolymerized.

As perfluoro(vinyl ether), a compound represented by $CF_2 = CF\text{-}O\text{-}R_f^1$ (wherein $R_f^1$ is a linear or branched perfluoroalkyl group having 1 to 8 carbon atoms or a perfluoro oxyalkyl group having 1 to 20 carbon atoms). Specific examples are perfluoro(alkyl vinyl ether) such as perfluoro(methyl vinyl ether), perfluoro(ethyl vinyl ether), perfluoro (propyl vinyl ether) and perfluoro(butyl vinyl ether) and perfluoro(alkoxy vinyl ether) such as $CF_2 = CFO[CF_2CF(CF_3)O]_2CF_2CF_2CF_3$. Particularly, perfluoro(methyl vinyl ether) (PMVE) is preferable from the viewpoint that mechanical strength of the molded article is excellent.

Examples of the crosslinkable group are carboxyl (COOH) groups, alkoxycarbonyl (COOR) groups, cyano (CN) groups, iodine atoms and bromide atoms. COOH groups, COOR groups and CN groups, which can take on a heat resistant crosslinking structure when crosslinking, are preferable and COOH groups and CN groups, which give a crosslinking structure that is excellent in heat resistance, are particularly suitable.

Examples of monomers that give such crosslinking groups are a monomer containing a cyano group, a monomer containing a carboxyl group and a monomer containing an alkoxycarbonyl group, represented by the following formulas:

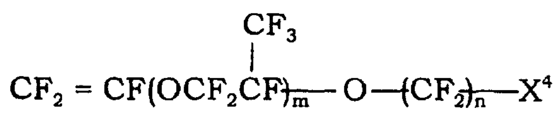

(wherein m is 0 to 5 and n is 1 to 8),

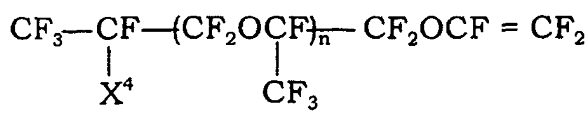

(wherein n is 1 to 4),

$$CF_2 = CFO(CF_2)_n OCF(CF_3)X^4$$

(wherein n is 2 to 5),

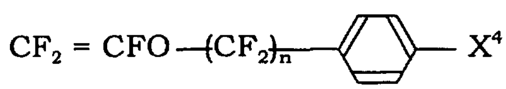

(wherein n is 1 to 6),

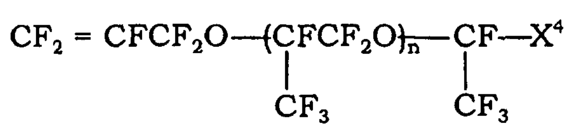

(wherein n is 1 to 5), or

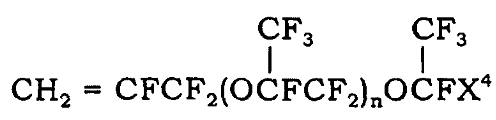

(wherein n is 0 to 5),
[$X^4$ is CN, COOH or $COOR^5$ (wherein $R^5$ is an alkyl group having 1 to 10 carbon atoms, which may contain a fluorine atom)]. Of these, a monomer containing cyano group and a monomer containing a carboxyl group are preferable, from the viewpoints that crosslinking reactivity is favorable and a molded article that is excellent in heat resistance can be

provided.

Specific examples of the fluorine-containing elastomer are as follows, but not limited thereto.

(1) TFE/PMVE/$CF_2$ = $CFOCF_2CF(CF_3)OCF_2CF_2CN$
(50 to 75/25 to 50/0.1 to 20 % by mol)

This elastomer is preferable from the viewpoints that crosslinking reactivity is favorable and a molded article that is excellent in heat resistance is provided.

(2) TFE/PMVE/$CF_2$ = $CFOCF_2CF_2CF_2OCF(CF_3)CN$
(50 to 75/25 to 50/0.1 to 20 % by mol)

This elastomer is preferable from the viewpoints that crosslinking reactivity is favorable and a molded article that is excellent in heat resistance is provided.

(3) TFE/$CF_2$ = $CF(OCF_2CF(CF_3))_2OCF_2CF_2CF_3$/$CF_2$ = $CFOCF_2CF(CF_3)OCF_2CF_2CN$ (60 to 85/15 to 40/0.1 to 20 % by mol)

This elastomer is preferable from the viewpoints that crosslinking reactivity is favorable and a molded article that is excellent in heat resistance and flexibility in low temperatures is provided.

A specific example of the other fluorine-containing elastomer used in the present invention is preferably a crosslinkable fluorine-containing elastomer or a segmented fluorine-containing elastomer represented by formula (I):

$$X^1\text{-}[A\text{-}(Y^1)_p]_q\text{-}[B\text{-}(Y^2)_r]_s\text{-}X^2 \qquad (I)$$

(wherein $X^1$ and $X^2$ can be randomly changed by changing the initiator or the chain transfer agent for polymerization or by modifying the terminal group and are not particularly limited; $X^1$ and $X^2$ can be the same or different and can be a carboxyl group, an alkoxycarbonyl group, a cyano group, an iodine atom, a bromine atom or a sulfonic acid group; $Y^1$ and $Y^2$ can be the same or different and can be a divalent organic group having a carboxyl group, alkoxycarbonyl group or cyano group in the side chain; A is an elastomeric fluorine-containing polymer chain segment; B is a non-elastomeric fluorine-containing polymer chain segment; p is an integer of 0 to 50, q is an integer of 1 to 5, r is an integer of 0 to 10, s is an integer of 0 to 3; one of $X^1$, $X^2$, $Y^1$ and $Y^2$ is a cyano group, carboxyl group or alkoxycarbonyl group and $Y^1$ or $Y^2$ may be randomly included in the segment A or B) and has, as the crosslinking site, a carboxyl group, a cyano group and/or an alkoxycarbonyl group at the terminal of the main chain and/or in the branched chain. The segmented fluorine-containing elastomer is described in detail in WO 99/24484 and can be applied to the present invention.

The above fluorine-containing elastomer can be prepared by polymerization methods such as emulsion polymerization, suspension polymerization and solution polymerization.

As a polymerization initiator, an initiator capable of introducing a carboxyl group or a group capable of producing a carboxyl group (for example, carboxyl fluoride, carboxyl chloride, $CF_2OH$, all of which produce a carboxyl group in the presence of water) into the elastomer terminal is preferably used. Examples are ammonium persulfate (APS) and potassium persulfate (KPS).

Furthermore, a chain transfer agent that is usually used to adjust molecular weight can be used, but is preferably used as little as possible, as the ratio of groups capable of producing carboxyl groups that are introduced into the terminal decreases. However, this does not apply when the chain transfer agent is capable of introducing the above group into the elastomer terminal. When a chain transfer agent is not used, the molecular weight can be adjusted by conducting polymerization under low pressure, for example less than 2 MPa·G, more preferably at most 1 MPa·G. Other polymerization conditions are not particularly limited. However, in order to obtain a polymerization product having a carboxyl group in the terminal and/or the branched chain without subjecting to the acid treatment described below, the pH of the polymerization system is preferably set to a strong acidic value of at most pH 3.

Some of the polymerization products obtained in this way do not contain free carboxyl groups depending on the polymerization conditions, but by subjecting to the following acid treatment, the groups can be converted into free carboxyl groups.

With respect to the fluorine-containing elastomer used in the present invention, groups such as metallic salt and ammonium salt of carboxylic acid that are present in the polymerization product are preferably converted into carboxyl groups by subjecting the polymerization product to acid treatment. As the method for acid treatment, the method of cleaning with hydrochloric acid, sulfuric acid or nitric acid and the method of adjusting the pH of the system after polymerization reaction to at most pH 3 with these acids are suitable.

From the viewpoint of simplifying the process, this acid treatment is preferably applied as a means for coagulation when isolating the polymerization product from the polymerization reaction mixture by coagulation. Also, the

polymerization mixture can be subjected to acid treatment and then the polymer product can be isolated by means of lyophilization. Furthermore, the methods of aggregation by ultrasonic waves or mechanical power can be employed.

Also, a carboxyl group can be introduce by oxidizing a fluorine-containing elastomer containing iodine or bromine by fuming sulfuric acid.

When the crosslinkable group that is to be introduced into the fluorine-containing elastomer is a COOH group or a CN group, the amount of the crosslinkable group is at least 0.1 % by mol, preferably at least 0.2 to 5 % by mol, further preferably at least 0.2 to 3 % by mol, from the viewpoint of optimizing the crosslinking density.

The amount of the inorganic filler is preferably 0.5 to 150 parts by weight, preferably 0.5 to 100 parts by weight, further preferably 1 to 50 parts by weight, based on 100 parts by weight of the crosslinkable fluorine-containing elastomer. When the amount is too small, the effects of adding the inorganic filler are not obtained and when the amount is too large, sealing properties of the molded article decrease and hardness increases.

In the present invention, crosslinking can be conducted in various crosslinking types, but in order to improve heat resistance, the crosslinking type is preferably a heat resistant crosslinking type, excluding a peroxide crosslinking type in which only a non-fluorine crosslinking agent is used. An example of "a peroxide crosslinking type in which only a non-fluorine crosslinking agent is used" is a peroxide crosslinking type in which a crosslinking accelerator such as triallyl isocyanurate (TAIC) and a peroxide crosslinking agent is used. Sufficient heat resistance cannot be obtained by this crosslinking type.

A crosslinking type that gives particularly excellent heat resistance is a type in which the crosslinkable group is a COOH group or a CN group and a crosslinking agent represented by the above formulas (1) to (5) is used as the crosslinking agent.

Examples of the crosslinking agent of formula (1) are 2,2-bis(3-amino-4-hydroxyphenyl)hexafluoropropane (generic name: bis(aminophenol)AF), 2,2-bis(3-amino-4-mercaptophenyl)hexafluoropropane, tetraaminobenzene, bis-3,4-diaminophenylmethane, bis-3,4-diaminophenyl ether, 2,2-bis-(3,4-diaminophenyl)hexafluoropropane, 2,2-bis [3-amino-4(N-methylamino)phenyl]hexafluoropropane and 2,2-bis[3-amino-4(N-phenylamino)phenyl]hexafluoropropane.

Examples of the crosslinking agent of formula (2) are 2,2-bis[N-(2-aminophenyl)-(3-aminophenyl)]hexafluoropropane and 2,2-bis[N-(2-aminophenyl)-(4-aminophenyl)]hexafluoropropane.

An example of the crosslinking agent of formula (3) is

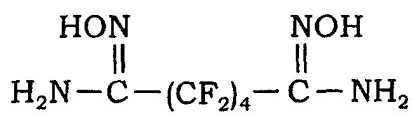

.

Examples of the crosslinking agent of formula (4) are perfluoro bisamidrazone adipate and perfluoro bisamidrazone suberate.

Examples of the crosslinking agent of formula (5) are

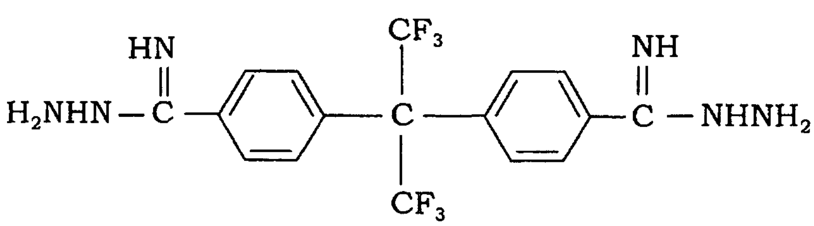

,

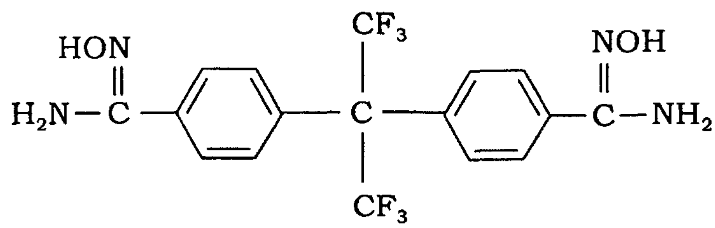

.

Of these, from the viewpoint of improving heat resistance and chemical resistance of the molded article, the crosslinking agents of formula (1) and (2) are preferable, particularly 2,2-bis[3-amino-4(N-phenylamino)phenyl]hexafluoropropane (bis AF-PA), 2,2-bis[N-(2-aminophenyl)-(3-aminophenyl)]hexafluoropropane and 2,2-bis[N-(2-aminophenyl)-(4-aminophenyl)]hexafluoropropane.

The amount of the crosslinking agent is 0.1 to 10 parts by weight, preferably 0.5 to 5 parts by weight, based on 100 parts by weight of the elastomer.

Furthermore, when necessary, a crosslinking accelerator can be compounded instead of or in addition to the crosslinking agent. Examples of the crosslinking accelerator are organic tin compounds, organic and/or inorganic ammonium salt that generate ammonia gas at 120 to 225°C, organic and/or inorganic compounds that generate ammonia gas at 40 to 330°C and ammonia adsorbed by an inactive carrier. In the case that the crosslinking accelerator is used alone instead of the crosslinking agent, the crosslinking type is a triazine crosslinking type.

The amount of the crosslinking accelerator is 0.01 to 10 parts by weight, preferably 0.01 to 5 parts by weight, based on 100 parts by weight of the elastomer.

As the crosslinking type, besides those described above, a polyol crosslinking type can be employed. As the crosslinking agent, fluorinated triallyl isocyanurate (F-TAIC; for example US 4,320,216), in which the hydrogen atoms in the three allyl groups of triallyl isocyanurate are substituted with fluorine atoms, is preferable from the viewpoint that a molded article having excellent heat resistance is provided. In the case that F-TAIC is used, the crosslinking type can be a peroxide crosslinking type.

In the present invention, when necessary, additives that are usually compounded in a crosslinkable fluorine-containing elastomer composition can be compounded, such as a filler, a processing aid, a plasticizer and a colorant. At least one type of a commonly used crosslinking agent and a crosslinking accelerator that differ from those described above may also be compounded. Furthermore, a known fluorine rubber may be compounded, as long as the effects of the present invention are not lost.

The crosslinkable fluorine-containing elastomer composition can be prepared by mixing the above components using a typical rubber-processing machine such as an open roll, a Banbury mixer or a kneader. The composition can also be prepared by the method of using an internal mixer and the method of co-coagulating from the emulsion mixture.

The method for obtaining a pre-molded article from the above composition can be the usual method and known methods such as the method of heat compressing in a metal mold, the method of injecting into a heated metal mold and the method of extruding with an extruder can be used. Extruded products such as a hose and electric wire can maintain its form after extrusion and therefore, the pre-molded article extruded without using a crosslinking agent can be used as it is. A pre-molded article subjecting to heat crosslinking by steam using a crosslinking agent can also be used. Also, in the case that maintaining the shape of a molded article such as an O-ring is difficult in an uncrosslinked state after mold-releasing, the article can maintain the shape by using a pre-molded article that is crosslinked in advance using a crosslinking agent.

The present invention relates to an elastomer molded article obtained by crosslinking in this way.

The molded article of the present invention has high mechanical strength and heat resistance. Furthermore, compression set, the standard for evaluating sealing properties, which are essential for sealing material, is surprisingly reduced to at most 50 %, preferably at most 40 %, further preferably at most 30 %, even in a high temperature of 275°C.

Also, plasma resistance is improved. For example, when a molded article (O-ring: AS-568A-214) that is heated for 24 hours at 200°C in nitrogen gas current after cleaning is irradiated by $NF_3$ plasma under the above irradiation conditions (2), the decrease in weight is kept to at most 3 %, more preferably at most 2 %.

Examples of methods for cleaning are preferably special cleaning methods described in WO 99/49997, such as the method of cleaning with ultra pure water, the method of cleaning with a clean organic compound or an inorganic aqueous solution that is liquid at the cleaning temperature, the method of dry etch cleaning and the method of extractive cleaning. By subjecting to these cleaning treatments, a molded article for semiconductor manufacturing equipment can be obtained, which is cleaned to an extremely high degree, generates a small amount of out gas and is excellent

in plasma resistance.

The fluorine-containing elastomer molded article of the present invention can be suitably used for a molded article for semiconductor manufacturing equipment, particularly for a sealing material for sealing in a semiconductor manufacturing equipment in which a high degree of cleanliness is required, specifically semiconductor manufacturing equipment in which high density plasma irradiation is conducted. Examples of the sealing material are an O-ring, a square-ring, a gasket, a packing, an oil seal, a bearing seal and a lip seal.

Also, the various elastomer products used in a semiconductor manufacturing equipment can be used as a diaphragm, a tube, a hose and various rubber rolls. The elastomer products can also be used as laminating material and lining material.

The semiconductor manufacturing equipment in the present invention is not particularly limited to equipment for manufacturing semiconductors and includes manufacturing equipment in general that is used in the semiconductor field, which require a high degree of cleanliness, such as equipment for manufacturing liquid crystal panels and plasma panels.

Specifically, the following are examples of semiconductor manufacturing equipment.

(1) Etching system

- Dry etching equipment
  - Plasma etching machine
  - Reactive ion etching machine
  - Reactive ion beam etching machine
  - Sputter etching machine
  - Ion beam etching machine
- Wet etching equipment
- Ashing equipment

(2) Cleaning system

- Dry etching cleaning equipment
  - $UV/O_3$ cleaning machine
  - Ion beam cleaning machine
  - Laser beam cleaning machine
  - Plasma cleaning machine
  - Gas etching cleaning machine
- Extractive cleaning equipment
  - Soxhlet extractive cleaning machine
  - High temperature high pressure extractive cleaning machine
  - Microwave extractive cleaning machine
  - Supercritical extractive cleaning machine

(3) Exposing system

- Stepper
- Coater and developer

(4) Polishing system

- CMP equipment

(5) Film forming system

- CVD equipment
- Sputtering equipment

(6) Diffusion and ion implantation system

Oxidation and diffusion equipment
Ion implantation equipment

Hereinafter, the present invention is explained based on Examples, but the present invention is not limited thereto.

The average primary particle size and the diffraction chart by X-ray crystal structure diffraction measured in Examples and Comparative Examples were measured by the following methods.

(Primary particle size)

The particle size was calculated according to the following equation from BET specific surface area s ($m^2/g$) found from nitrogen gas adsorption and density d ($g/cm^3$) of the inorganic compound that constitutes the inorganic filler. The filler is assumed to be true sphere particles, all having the same size.

$$\text{Particle size (nm)} = 6 \times 10^3/(d \times s)$$

The density of aluminum oxide is 3.9 $g/cm^3$, the density of aluminum nitride is 3.05 $g/cm^3$ and the density of titanium dioxide is 4.26 $g/cm^3$. With respect to other inorganic compounds, the usual value, such as the value shown in Unabridged Chemical Dictionary (Kyoritsu Shuppan Co., Ltd.), can be used.

(X-ray crystal structure diffraction)

Measurement device: X-ray diffractometer (RAD-RA (trade name) made by Rigaku Corporation)
X-ray source: Cu-K$\alpha$ (monochromatized by a monochromator)
Measurement range: $2\theta$ = 5 to 80°

PREPARATION EXAMPLE 1

(Preparation of fluorine-containing elastomer having a CN group)

A 6 liter stainless steel autoclave without an ignition source was charged with 2 liters of deionized water, 20 g of

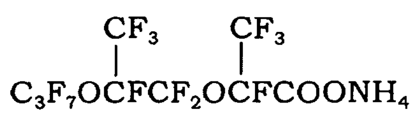

as an emulsifying agent and 0.18 g of disodium hydrogenphosphate-12 $H_2O$ as a pH adjuster. After the system was sufficiently replaced with nitrogen gas to deaerate the system, the autoclave was heated to 50°C while stirring at 600 rpm. Then, mixed gas of tetrafluoroethylene (TFE) and perfluoro(methyl vinyl ether) (PMVE) (TFE/PMVE = 25/75 in mol ratio) was fed so that the inside pressure became 0.78 MPa·G. Subsequently, 20 ml of an aqueous solution of ammonium persulfate (APS) having concentration of 527 mg/ml was injected by nitrogen pressure to initiate the reaction.

When the inside pressure was lowered to 0.69 MPa·G as polymerization progressed, 4.6 g of $CF_2 = CFOCF_2CF(CF_3)OCF_2CF_2CN$ (CNVE) was injected by nitrogen pressure. Then, 9.4 g of TFE and 10.6 g of PMVE were respectively injected by their own pressure so that the inside pressure became 0.78 MPa·G. Thereafter, as the reaction proceeds, TFE and PMVE were injected in the same manner and increase and decrease in pressure were repeated between 0.69 MPa·G and 0.78 MPa·G. At the points when the total amount of TFE and PMVE reached 140 g, 260 g, 380 g and 500 g, 4.6 g of CNVE was injected by nitrogen pressure.

Twenty hours after initiation of the polymerization reaction, when the total amount of TFE and PMVE reached 600 g, the autoclave was cooled and unreacted monomers were discharged to obtain 2650 g of an aqueous dispersion having solid content concentration of 21.2 % by weight.

2400 g of the aqueous dispersion was diluted with 7200 g of water and slowly added while stirring to 5600 g

of a 3.5 % by weight aqueous solution of hydrochloric acid. After the solution was stirred for 5 minutes after adding, the precipitate was filtrated. The obtained polymer was added to 4 kg of HCFC-141b, stirred for 5 minutes and then filtrated again. Thereafter, the steps of cleaning with HCFC-141 b and filtrating were repeated four more times and then the polymer was vacuum dried at 60°C for 72 hours to obtain 500 g of a fluorine-containing elastomer precipitate having a CN group.

As a result of $^{19}$F-NMR analysis, the monomer unit composition of the elastomer was found to be TFE/PMVE/CNVE = 59.1/40.0/0.9 % by mol. This perfluoro elastomer having a CN group is referred to as "Elastomer A".

PREPARATION EXAMPLE 2

(Preparation of fluorine-containing elastomer having iodine)

A 6 liter stainless steel autoclave without an ignition source was charged with 2 liters of deionized water, 20 g of $C_7F_{15}COONH_4$ as an emulsifying agent and 0.18 g of disodium hydrogenphosphate·12 $H_2O$ as a pH adjustor. After the system was sufficiently replaced with nitrogen gas to deaerate the system, the autoclave was heated to 50°C while stirring at 600 rpm. Then, mixed gas of TFE and PMVE (TFE/PMVE = 27/73 in mol ratio) was fed so that the inside pressure became 1.18 MPa·G. Subsequently, 2 ml of an aqueous solution of ammonium persulfate (APS) having concentration of 186 mg/ml was injected by nitrogen pressure to initiate the reaction.

When the inside pressure was lowered to 1.08 MPa·G as polymerization progressed, 4.0 g of $I(CF_2)_4I$, which is a diiodo compound, was injected by nitrogen pressure. Then, 21.0 g of TFE and 21.0 g of PMVE were respectively injected so that the inside pressure became 1.18 MPa·G. Thereafter, as the reaction progressed, TFE and PMVE were injected and increase and decrease in pressure were repeated in the same manner. At the points when the total amount of TFE and PMVE reached 430 g, 511 g, 596 g and 697 g, 1.5 g of $ICH_2CF_2CF_2OCF = CF_2$, which is an iodine compound, was injected by nitrogen pressure and every 12 hours after the reaction was started, 2 ml of an aqueous solution of 35 mg/ml of APS was injected by nitrogen pressure to continue the reaction. Polymerization was stopped after 29 hours.

The obtained aqueous dispersion was frozen in dry ice/methanol to coagulate and after defrosting, the precipitate was washed with water and then vacuum dried to obtain 847 g of an elastomer. The Mooney viscosity ML1+10 (100°C) of the elastomer was 58.

As a result of $^{19}$F-NMR analysis, the monomer unit composition of the elastomer excluding iodine-containing monomer units was found to be TFE/ PMVE = 62.9/37.1 % by mol and the iodine content calculated from elemental analysis was 0.28 % by weight. This iodine-containing perfluoro elastomer is referred to as "Elastomer B".

EXAMPLE 1

The fluorine-containing elastomer containing a CN group having a carboxyl group at the terminal obtained in Preparation Example 1 (Elastomer A), 2,2-bis[3-amino-4-(N-phenylamino)phenyl]hexafluoropropane (crosslinking agent A), which is a crosslinking agent synthesized by the method described in Journal of Polymer Science, Polymer Chemistry edition, Vol. 20, pages 2381 to 2393 (1982), and an aluminum oxide filler (AKP-50 (trade name), available from Sumitomo Chemical Co., Ltd., average primary particle size: 0.15 μm, crystal type: essentially α-type only, see Fig. 1) were mixed in a weight ratio of 100/4.25/15 and kneaded by an open roll to prepared a crosslinkable fluorine-containing elastomer composition.

The fluorine-containing elastomer composition was crosslinked by pressing for 25 minutes at 180°C and then subjected to oven crosslinking for 18 hours in a 290°C oven, to prepare O-ring (AS-568A-214) test samples. The compression set and decrease in weight by $NF_3$ plasma irradiation of the test sample were measured. The results are shown in Table 4.

(Compression set)

According to JIS K6262-1997, the compression set of the O-ring (AS-568A-214) at 275°C after 70 hours was measured.

(Decrease in weight by $NF_3$ plasma irradiation)

Measurement device: ICP high-density plasma device (Model.RIE-101IPH (trade name), made by Samco International, Inc.)

Measurement conditions (2):

$NF_3$ flow rate: 16 SCCM
Pressure: 10 militorr
RF output: 800 W
Irradiation time: 30 minutes
Frequency: 13.56 MHz
Cleaning of test sample: The O-ring is thoroughly washed in a large amount of a mixture of $H_2SO_4/H_2O_2$ (weight ratio 6/4) at 100°C for 15 minutes while stirring. Subsequently, the O-ring is washed with 5 % HF for 15 minutes at 25°C and further cleaned by boiling in deionized water for 2 hours at 100°C. Thereafter, the O-ring is dried in a nitrogen gas current for 24 hours at 200°C.
Irradiation operation: In order to stabilize the atmosphere in the chamber of the plasma irradiation device, empty discharge of actual gas is conducted for 5 minutes as chamber pre-treatment. Then, the aluminum container holding the test sample is placed in the center of the RF electrode and plasma is irradiated under the above conditions.
Weight measurement: The O-ring was measured to 0.01 mg using an electronic analysis scale 2006 MPE (trade name) made by Sertorious GMBH and the 0.01 mg column was rounded off.

EXAMPLES 2 to 5

The fluorine-containing elastomer was prepared in the same manner as in Example 1, except that the inorganic fillers shown in Table 1 were used, and vulcanized and molded to prepare an O-ring (AS-568A-214).
Each of the prepared O-rings was measured for compression set and decrease in weight by $NF_3$ plasma irradiation in the same manner as in Example 1. The results are shown in Table 1.
The inorganic fillers shown in Table 1 are the following.

Filler 1 (Example 1): aluminum oxide filler (AKP-50 (trade name), available from Sumitomo Chemical Co., Ltd., average primary particle size: 0.15 μm, crystal type: essentially α-type only, see Fig. 1)
Filler 2 (Example 2): aluminum oxide filler (TM-DAR (trade name), available from Taimei Chemicals Co., Ltd., average primary particle size: 0.11 μm, crystal type: essentially α-type only, see Fig. 2)
Filler 3 (Example 3): aluminum oxide filler (UA-5105 (trade name), available from Showa Denko K.K., average primary particle size: 0.15 μm, crystal type: mainly α-type, see Fig. 3)
Filler 4 (Example 4): aluminum oxide filler (UA-5205 (trade name), available from Showa Denko K.K., average primary particle size: 0.09 μm, crystal type: mainly α-type, see Fig. 4)
Filler 5 (Example 5): aluminum nitride filler (High purity aluminum nitride powder Grade F (trade name), available from Tokuyama Corp., average primary particle size: 0.58 μm)

TABLE 1

| | Example | | | | |
|---|---|---|---|---|---|
| | 1 | 2 | 3 | 4 | 5 |
| Fluorine-containing elastomer | Elastomer A | Elastomer A | Elastomer A | Elastomer A | Elastomer A |
| Crosslinking agent | Crosslinking agent A | Crosslinking agent A | Crosslinking agent A | Crosslinking agent A | Crosslinking agent A |
| Inorganic filler | Filler 1 | Filler 2 | Filler 3 | Filler 4 | Filler 5 |
| Type | Aluminum oxide | Aluminum oxide | Aluminum oxide | Aluminum oxide | Aluminum nitride |
| Crystal type | (α-type only) | (α-type only) | (α-type only) | (mainly α-type) | - |
| Diffraction chart | Fig. 1 | Fig. 2 | Fig. 3 | Fig. 4 | - |
| Average primary particle size (μm) | 0.15 | 0.11 | 0.15 | 0.09 | 0.58 |
| Compression set (275°C × 70 hr) | 20 % | 20 % | 18 % | 21 % | 17 % |
| Decrease in weight by plasma irradiation | 1.66 % | 1.65 % | 1.58 % | 1. 60 % | 1.73 % |

COMPARATIVE EXAMPLES 1 to 4

The fluorine-containing elastomer was prepared in the same manner as in Example 1, except that the inorganic fillers shown in Table 2 were used and crosslinking by pressing at 180°C was conducted for the times shown in Table 2, and vulcanized and molded to prepare an O-ring (AS-568A-214).

Each of the prepared O-rings was measured for compression set and decrease in weight by $NF_3$ plasma irradiation in the same manner as in Example 1. The results are shown in Table 2.

The inorganic fillers shown in Table 1 are the following.

Filler 6 (Comparative Example 1): aluminum oxide filler (AKP-G008 (trade name), available from Sumitomo Chemical Co., Ltd., average primary particle size: 0.02 μm, crystal type: major peaks are θ-type, see Fig. 5)
Filler 7 (Comparative Example 2): aluminum oxide filler used in Comparative Example 1 (AKP-G008 (trade name), available from Sumitomo Chemical Co., Ltd., average primary particle size: 0.02 μm, crystal type: major peaks are θ-type) sintered for 3 hours at 1100°C; α-type crystal and θ-type crystal coexist (see Fig. 6)
Filler 8 (Comparative Example 3): aluminum oxide filler (TM-300 (trade name), available from Taimei Chemicals Co., Ltd., average primary particle size: 0.007 μm, crystal type: major peaks are γ-type, see Fig. 7)
Filler 9 (Comparative Example 4): aluminum oxide filler ($Al_2O_3$-C (trade name), available from Degussa Hüls AG, average primary particle size: 0.015 μm, crystal type: major peaks are θ-type, see Fig. 8)

COMPARATIVE EXAMPLE 5

The fluorine-containing elastomer having an iodine terminal obtained in Preparation Example 2 (Elastomer B), Perhexa 25B (trade name, available from NOF Corporation) as a crosslinking accelerator, triallyl isocyanurate (TAIC) as a crosslinking agent and an aluminum oxide filler (filler 10, AO-802 (trade name) made by Tatsumori, average primary particle size: 0.26 μm, crystal type: essentially α-type only, see Fig. 9) were mixed in weight ratio of 100/10/1/3 and kneaded by an open roll to prepared a crosslinkable fluorine-containing elastomer composition.

This fluorine-containing elastomer composition was peroxide crosslinked under conditions of crosslinking by pressing at 160°C for 10 minutes (primary crosslinking) and crosslinking in an oven at 180°C for 4 hours (secondary crosslinking) to prepare O-ring (AS-58A-214) test samples. The compression set and decrease in weight by $NF_3$ plasma irradiation of the test samples were measured in the same way as in Example 1. The results are shown in Table 2.

COMPARATIVE EXAMPLE 6

A fluorine-containing elastomer was prepared in the same manner as in Comparative Example 5, except that filler 1 (AKP-50 (trade name), available from Sumitomo Chemical Co., Ltd., average primary particle size: 0.12 μm, crystal type: essentially α-type only, see Fig. 1) was used as the aluminum oxide filler and the mixing ratio of elastomer B, Perhexa 25B, TAIC and the aluminum oxide filler was 100/1.5/4.0/15 (weight ratio), and vulcanized and molded to prepare an O-ring (AS-568A-214).

The prepared O-ring was measured for compression set and decrease in weight by $NF_3$ plasma irradiation in the same manner as in Example 1. The results are shown in Table 2.

COMPARATIVE EXAMPLE 7

A fluorine-containing elastomer was prepared in the same manner as in Example 1, except that a titanium dioxide filler (filler 11, TM-1 (trade name), available from Fuji Titanium Industry Co., Ltd., crystal type: rutile type, average primary particle size: 0.28 μm) was used instead of the aluminum oxide filler and the mixing ratio of elastomer A, crosslinking agent A and filler 11 was 100/2.8/23 (weight ratio), and vulcanized and molded to prepare an O-ring (AS-568A-214).

The prepared O-ring was measured for compression set and decrease in weight by $NF_3$ plasma irradiation in the same manner as in Example 1. The results are shown in Table 2.

TABLE 2

| | Comparative Example | | | |
|---|---|---|---|---|
| | 1 | 2 | 3 | 4 |
| Fluorine-containing elastomer | Elastomer A | Elastomer A | Elastomer A | Elastomer A |
| Crosslinking agent | Crosslinking agent A | Crosslinking agent A | Crosslinking agent A | Crosslinking agent A |
| Crosslinking accelerator | - | - | - | - |
| Inorganic filler | Filler 6 | Filler 7 | Filler 8 | Filler 9 |
| Type | Aluminum oxide | Aluminum oxide | Aluminum oxide | Aluminum oxide |
| Crystal type | (θ-type only) | (α-type and θ-type mixed) | (γ-type only) | (δ-type only) |
| Diffraction chart | Fig. 5 | Fig. 6 | Fig. 7 | Fig. 8 |
| Average primary particle size (μm) | 0.02 | 0.02 | 0.007 | 0.015 |
| Press crosslinking time (180°C) | 25 minutes | 25 minutes | 160 minutes | 130 minutes |
| Compression set (275°C × 70 hr) | 61 % | 57 % | 70 % | 83 % |
| Decrease in weight by plasma irradiation | 1.65 % | 1.58 % | 1.71 % | 1.63 % |

-continued-

-continued-

| | Comparative Example 5 | Comparative Example 6 | Comparative Example 7 |
|---|---|---|---|
| Fluorine-containing elastomer | Elastomer B | Elastomer B | Elastomer A |
| Crosslinking agent | TAIC | TAIC | Crosslinking agent A |
| Crosslinking accelerator | Perhexa 25B | Perhexa 25B | - |
| Inorganic filler | Filler 10 | Filler 1 | Filler 11 |
| Type | Aluminum oxide | Aluminum oxide | Titanium dioxide |
| Crystal type | (α-type only) | (α-type only) | - |
| Diffraction chart | Fig. 9 | Fig. 1 | - |
| Average primary particle size (μm) | 0.26 | 0.15 | 0.28 |
| Press crosslinking time (180°C) | - | - | 25 minutes |
| Compression set (275°C × 70 hr) | 68 % | 63 % | 17 % |
| Decrease in weight by plasma irradiation | 2.17 % | 1.65 % | 5.98 % |

INDUSTRIAL APPLICABILITY

According to the present invention, a fluorine-containing elastomer molded article, which can withstand use in high temperatures of 275°C or higher and has resistance to high density plasma, can be provided.

## Claims

1. A fluorine-containing elastomer molded article obtained by crosslinking a crosslinkable elastomer composition comprising 0.5 to 100 parts by weight of an inorganic filler having a average primary particle size of at most 0.5 µm, based on 100 parts by weight of a fluorine-containing elastomer component;
wherein the compression set of said fluorine-containing elastomer molded article under the following conditions (1) is at most 50 % and the decrease in weight by $NF_3$ plasma irradiation of said fluorine-containing elastomer molded article under the following conditions (2) is at most 3 %.

    Conditions (1)
    Sample: O-ring (AS-568A-214)
    Measurement conditions: Compression set at 275°C after 70 hours is measured according to JIS K6262-1997
    Conditions (2)
    Sample: O-ring (AS-568A-214)
    Measurement device: ICP high-density plasma device
    Measurement conditions:

        $NF_3$ flow rate: 16 SCCM
        Pressure: 10 militorr
        RF output: 800 W
        Irradiation time: 30 minutes
        Frequency: 13.56 MHz

2. The elastomer molded article of Claim 1, which is obtained by crosslinking in a heat resistant crosslinking type excluding a peroxide crosslinking type wherein only a non-fluorine crosslinking agent is used.

3. The elastomer molded article of Claim 1 or 2, wherein said inorganic filler contains at least one kind of inorganic filler containing aluminum.

4. The elastomer molded article of Claim 1 or 2, wherein said inorganic filler consists of an inorganic filler containing aluminum.

5. The elastomer molded article of Claim 1 or 2, wherein said inorganic filler contains at least one kind of inorganic filler essentially consisting of aluminum as a metal atom.

6. The elastomer molded article of Claim 1 or 2, wherein said inorganic filler consists of an inorganic filler essentially consisting of aluminum as a metal atom.

7. The elastomer molded article of Claim 3, 4, 5 or 6, wherein said inorganic filler is an aluminum oxide filler, an aluminum nitride filler or an aluminum fluoride filler.

8. The elastomer molded article of Claim 7, wherein said inorganic filler is an aluminum oxide filler; and
six peaks selected in order of strength that appear in a diffraction chart when measured by X-ray crystal structure diffraction are all peaks that are essentially derived from α-type crystal structure of aluminum oxide.

9. The elastomer molded article of Claim 7, wherein said inorganic filler is an aluminum oxide filler; and
all peaks that appear in a diffraction chart when measured by X-ray crystal structure diffraction are peaks that are essentially only peaks that are derived from α-type crystal structure of aluminum oxide.

10. The elastomer molded article of Claim 1, 2, 3, 4, 5, 6, 7, 8 or 9, wherein the average primary particle size of said inorganic filler is at most 1.0 µm.

11. The elastomer molded article of Claim 1, 2, 3, 4, 5, 6, 7, 8 or 9, wherein the average primary particle size of said inorganic filler is at most 0.2 µm.

12. The elastomer molded article of Claim 1, 2, 3, 4, 5, 6, 7, 8, 9, 10 or 11, wherein said fluorine-containing elastomer is a perfluoro elastomer having a crosslinkable group.

**13.** The elastomer molded article of Claim 12, wherein said perfluoro elastomer having a crosslinkable group contains a structural unit derived from perfluoro olefin having 2 to 3 carbon atoms, a structural unit derived from perfluoro (vinyl ether) and a structural unit derived from a monomer capable of forming a crosslinkable group.

**14.** The elastomer molded article of Claim 1, 2, 3, 4, 5, 6, 7, 8, 9, 10, 11 or 12, wherein said fluorine-containing elastomer has a CN group and/or a COOH group as a crosslinkable group.

**15.** The elastomer molded article of Claim 1, 2, 3, 4, 5, 6, 7, 8, 9, 10, 11, 12, 13 or 14, wherein said crosslinkable fluorine-containing elastomer composition is a composition containing as a crosslinking agent, a compound represented by formula (1):

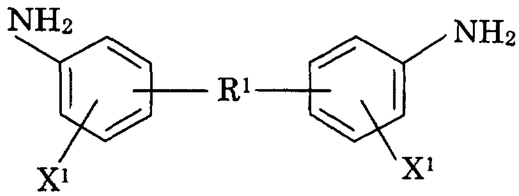

(wherein $R^1$ is $-SO_2-$, -O-, -C(=O)-,

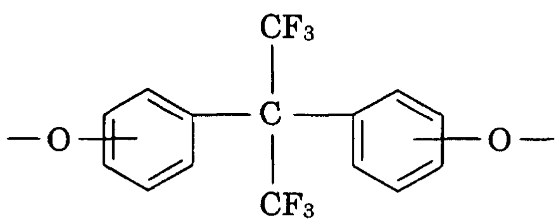

,

an alkylidene group having 1 to 10 carbon atoms, a perfluoro alkylidene group having 1 to 10 carbon atoms or a single bonding; $X^1$ is the same or different and is -OH, $-NH_2$, -SH, -NHR (R is a linear or branched alkyl group having 1 to 6 carbon atoms that can be substituted) or -NHAr (Ar is a phenyl group or a naphthyl group that can be substituted));
a compound represented by formula (2):

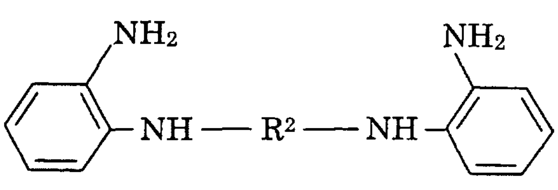

(wherein $R^2$ is a linear or branched alkylidene group that can be substituted, an arylene group that can be substituted,

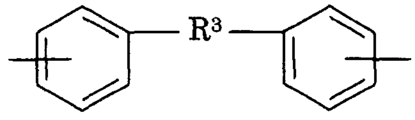

,

$R^3$ is $-SO_2-$, -O-, -C(=O)-,

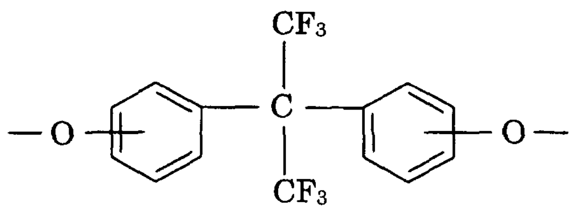

,

or a single bonding);
a compound represented by formula (3):

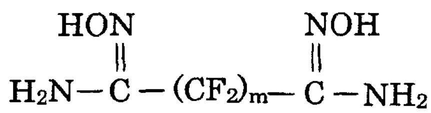

(wherein m is an integer of 1 to 10);
a compound represented by formula (4):

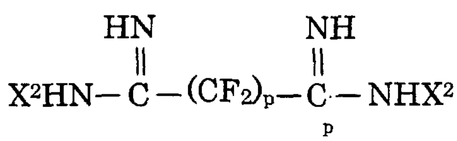

(wherein $X^2$ is the same or different and is H or $NH_2$; p is an integer of 1 to 10); and/or
a compound represented by formula (5):

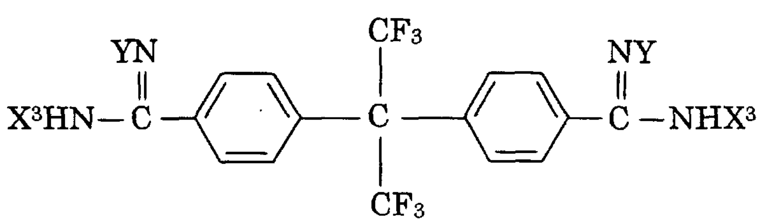

(wherein $X^3$ is the same or different and is H or $NH_2$; Y is the same or different and is H or OH).

**16.** The elastomer molded article of Claim 15, wherein said crosslinking agent is a compound wherein in formula (1), $R^1$ is

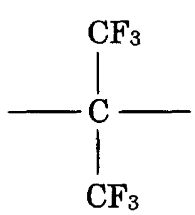

,

and $X^1$ is

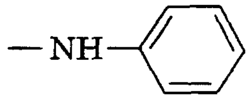

.

**17.** The elastomer molded article of Claim 14, wherein an organic tin compound is contained as a crosslinking accelerator.

**18.** The elastomer molded article of Claim 1, 2, 3, 4, 5, 6, 7, 8, 9, 10, 11, 12, 13, 14, 15, 16 or 17, which is used as sealing for semiconductor manufacturing equipment.

FIG. 1

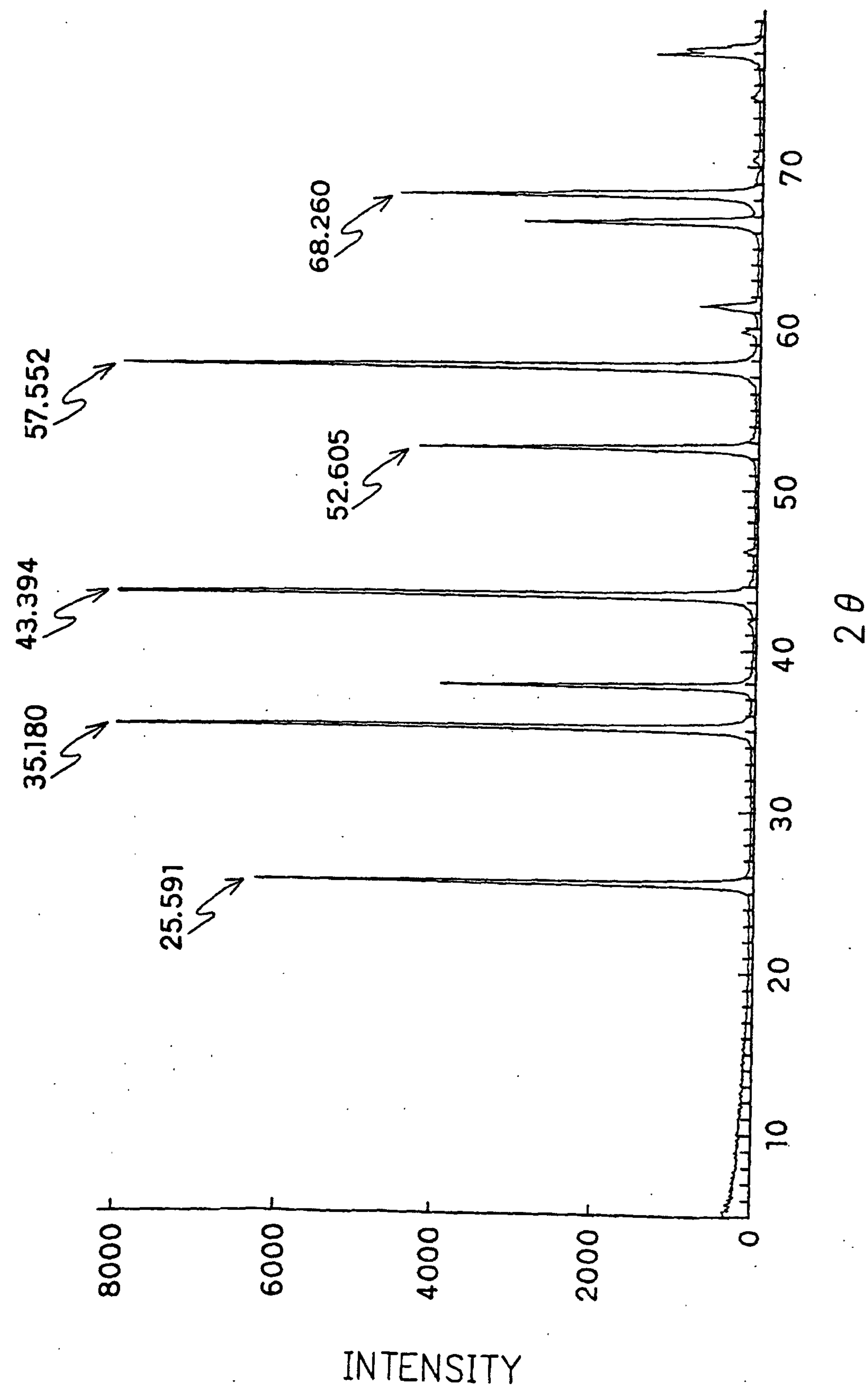
25.591
35.180
43.394
57.552
52.605
68.260
INTENSITY
8000
6000
4000
2000
0
10
20
30
40
50
60
70
2θ

FIG. 2

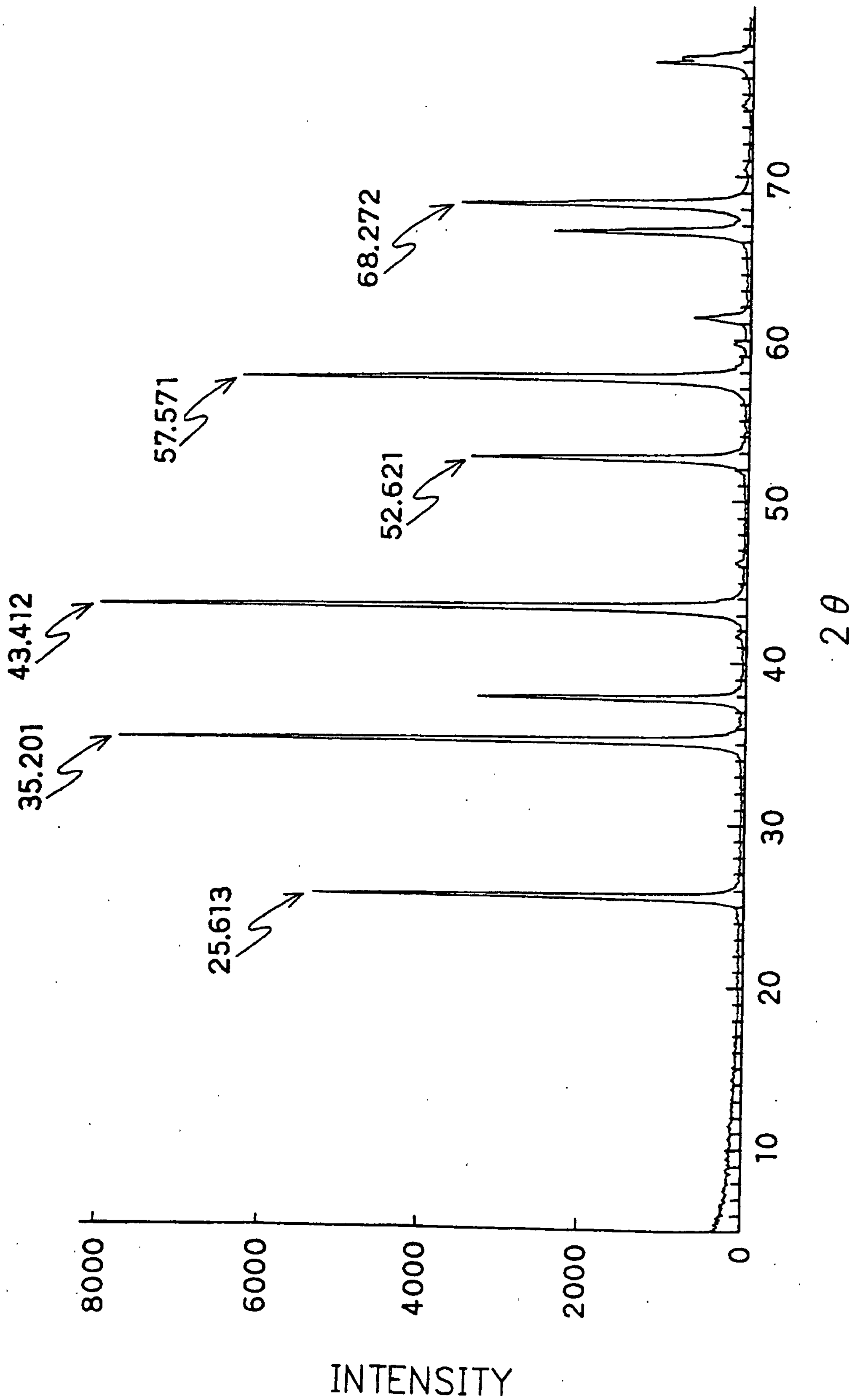
25.613
35.201
43.412
52.621
57.571
68.272
INTENSITY
0
2000
4000
6000
8000
2θ
10
20
30
40
50
60
70

FIG. 3

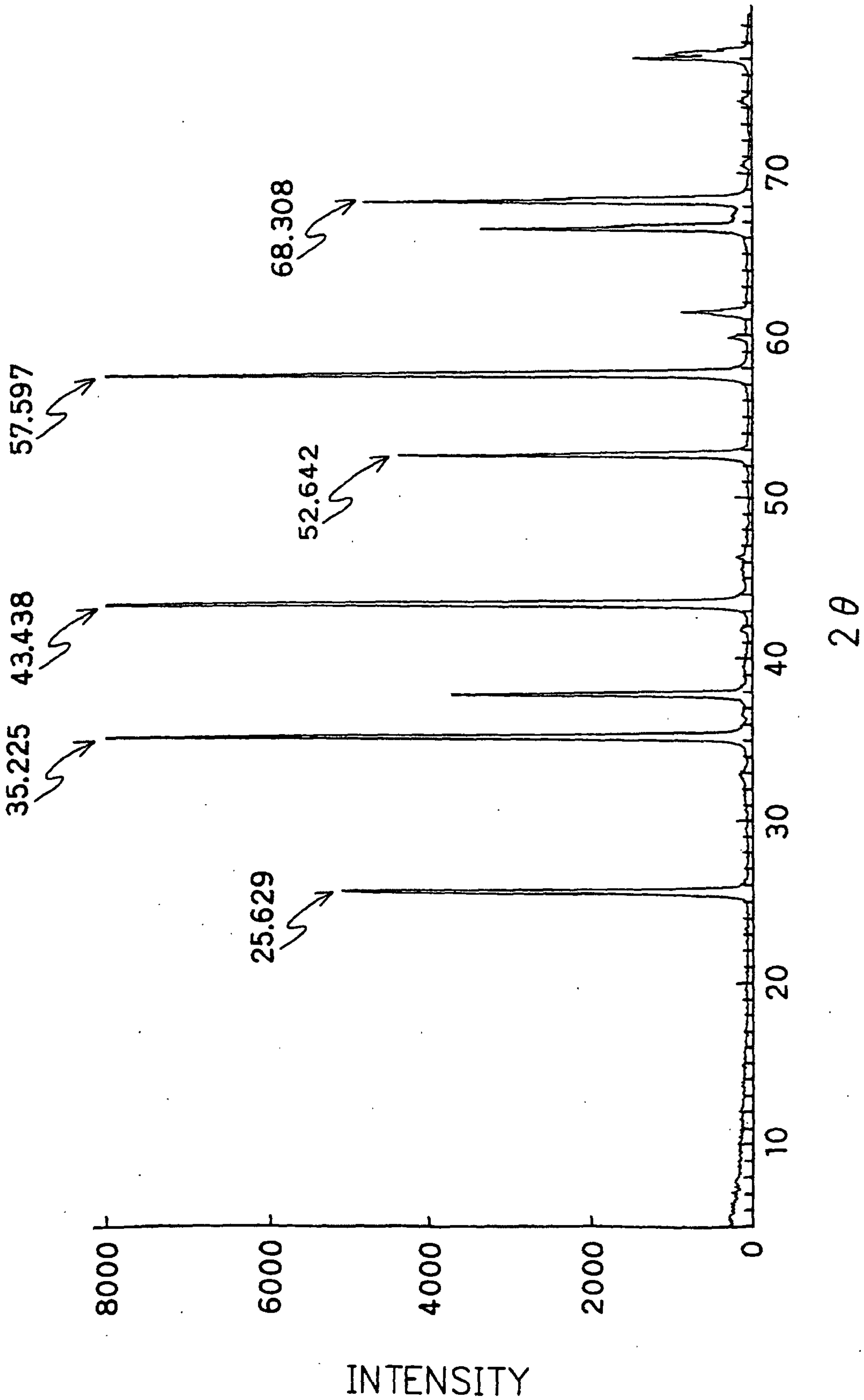
25.629
35.225
43.438
52.642
57.597
68.308
8000
6000
4000
2000
0
10
20
30
40
50
60
70
INTENSITY
2θ

FIG. 4

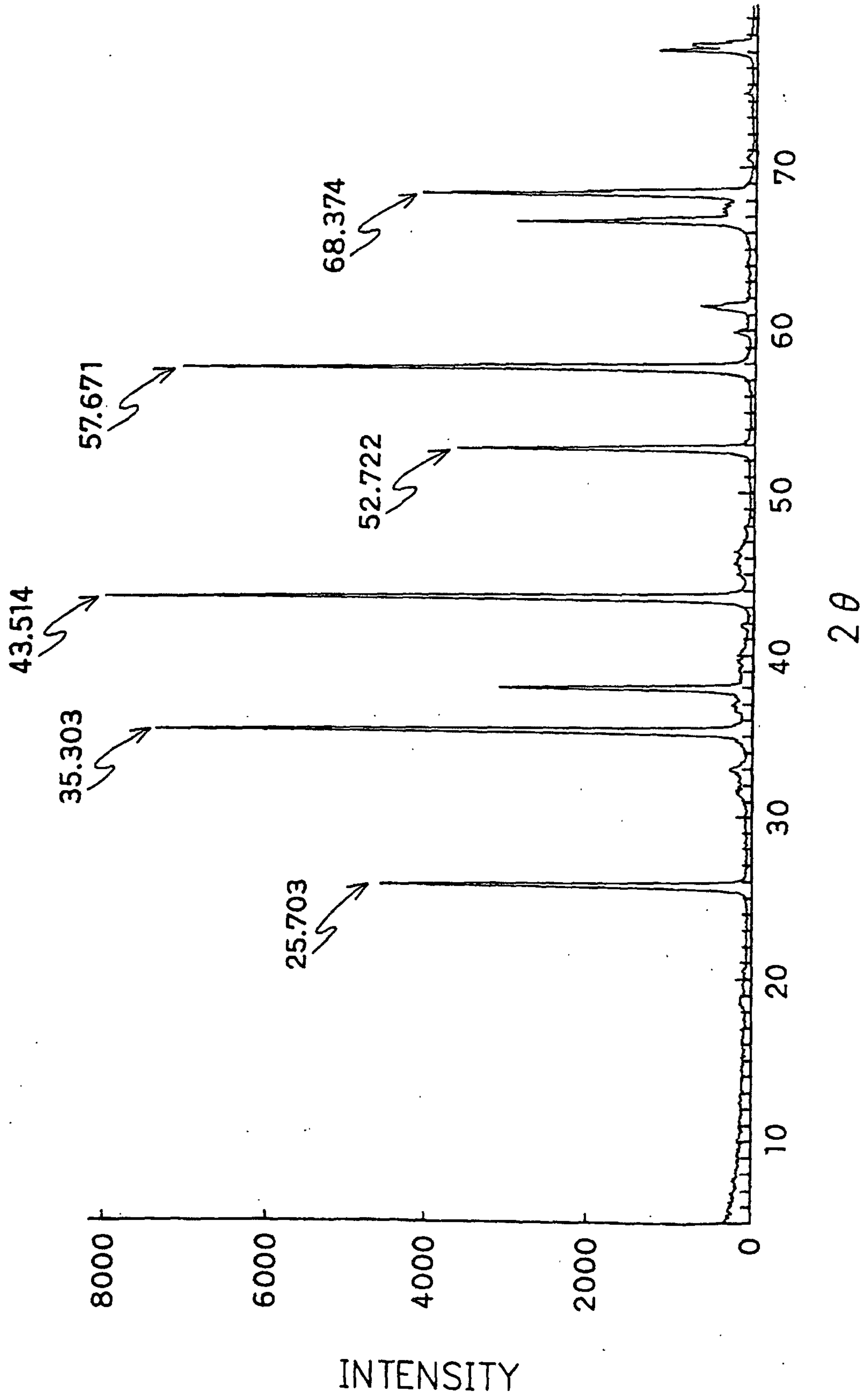
25.703
35.303
43.514
52.722
57.671
68.374
8000
6000
4000
2000
0
10
20
30
40
50
60
70
2θ
INTENSITY

FIG. 5

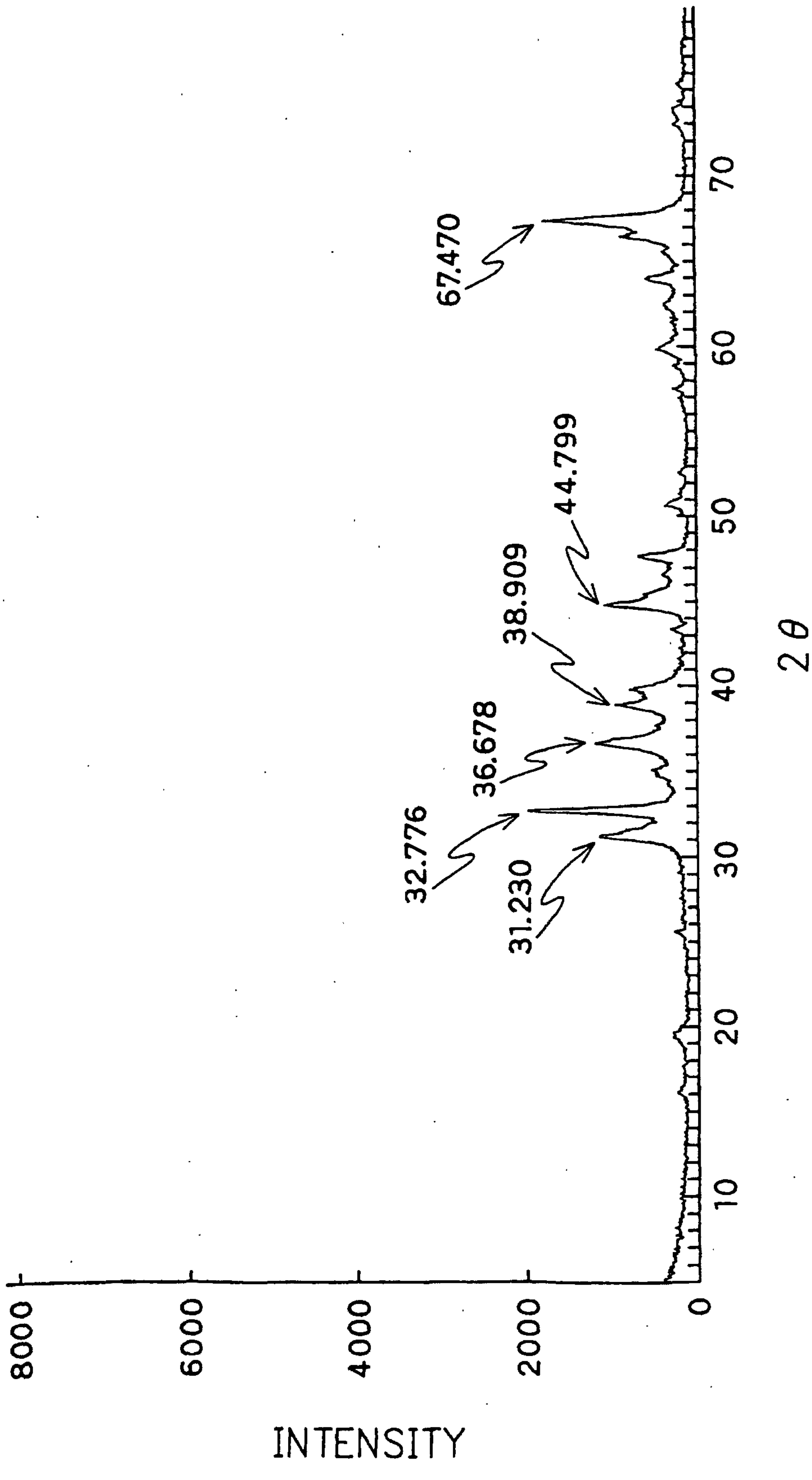

67.470
44.799
38.909
36.678
32.776
31.230
8000
6000
4000
2000
0
10
20
30
40
50
60
70
INTENSITY
2θ

FIG. 6

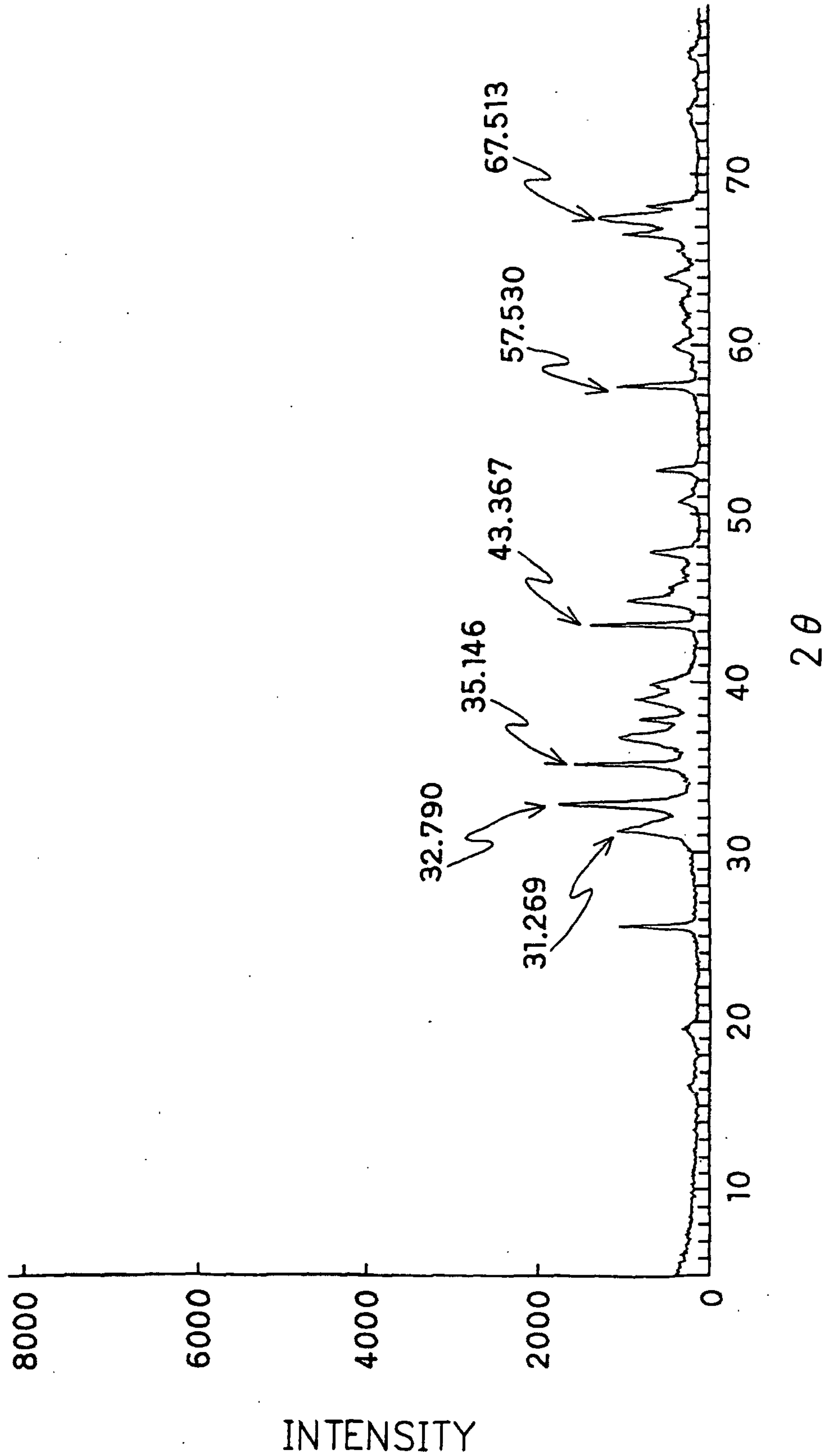
67.513
57.530
43.367
35.146
32.790
31.269
8000
6000
4000
2000
0
10
20
30
40
50
60
70
2θ
INTENSITY

FIG. 7

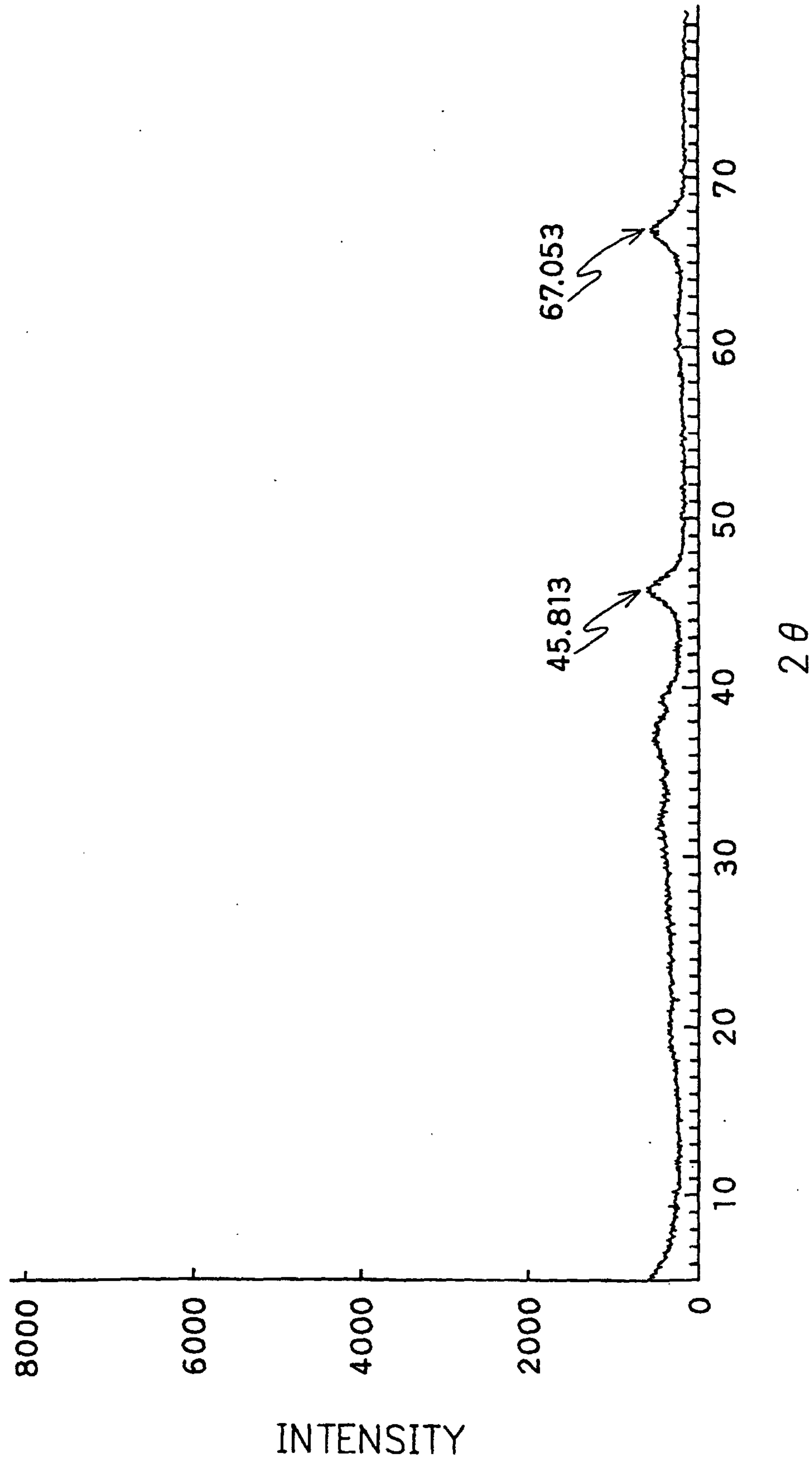
67.053
45.813
70
60
50
40
30
20
10
2θ
8000
6000
4000
2000
0
INTENSITY

FIG. 8

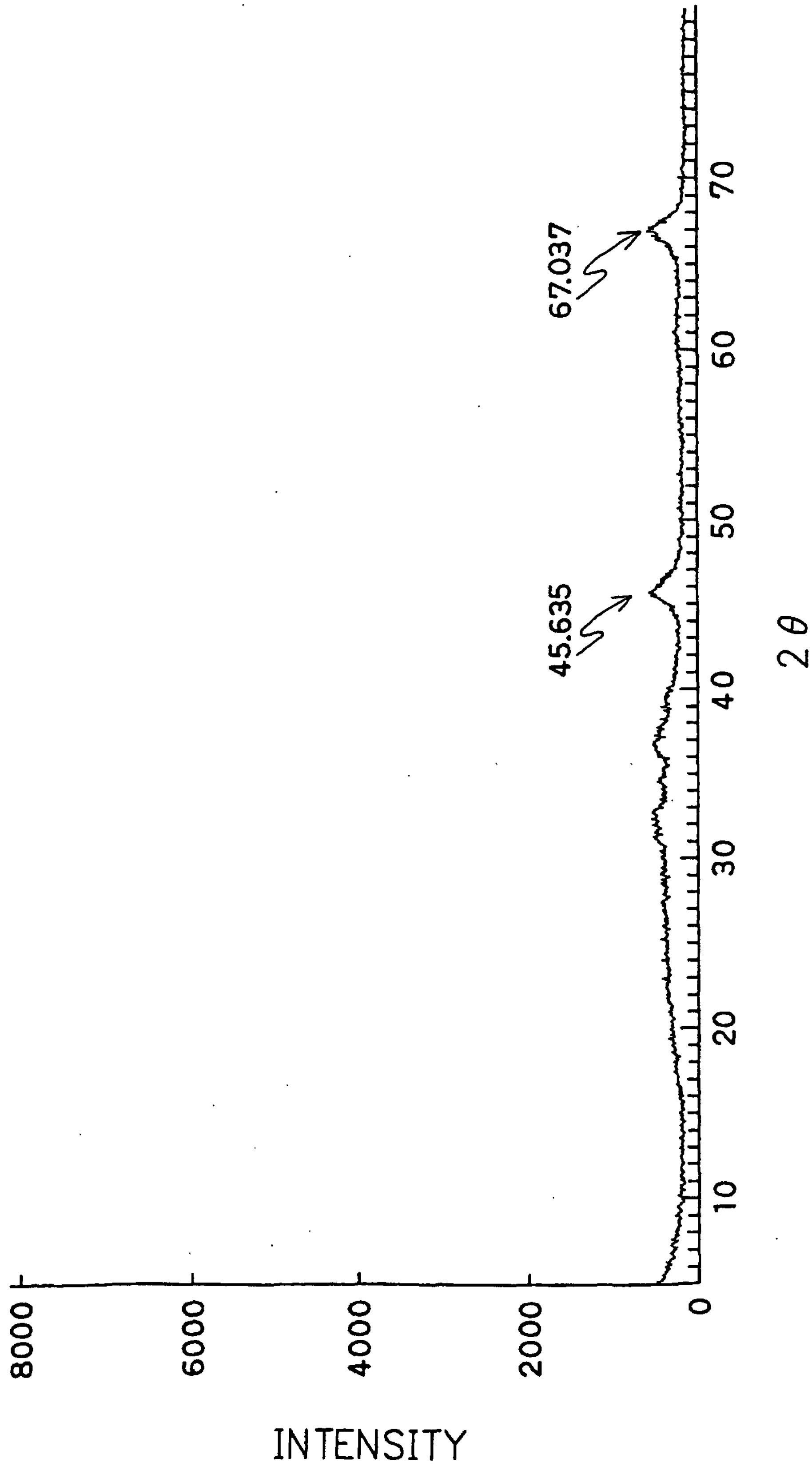
INTENSITY
8000
6000
4000
2000
0
10
20
30
40
50
60
70
2θ
45.635
67.037

FIG. 9

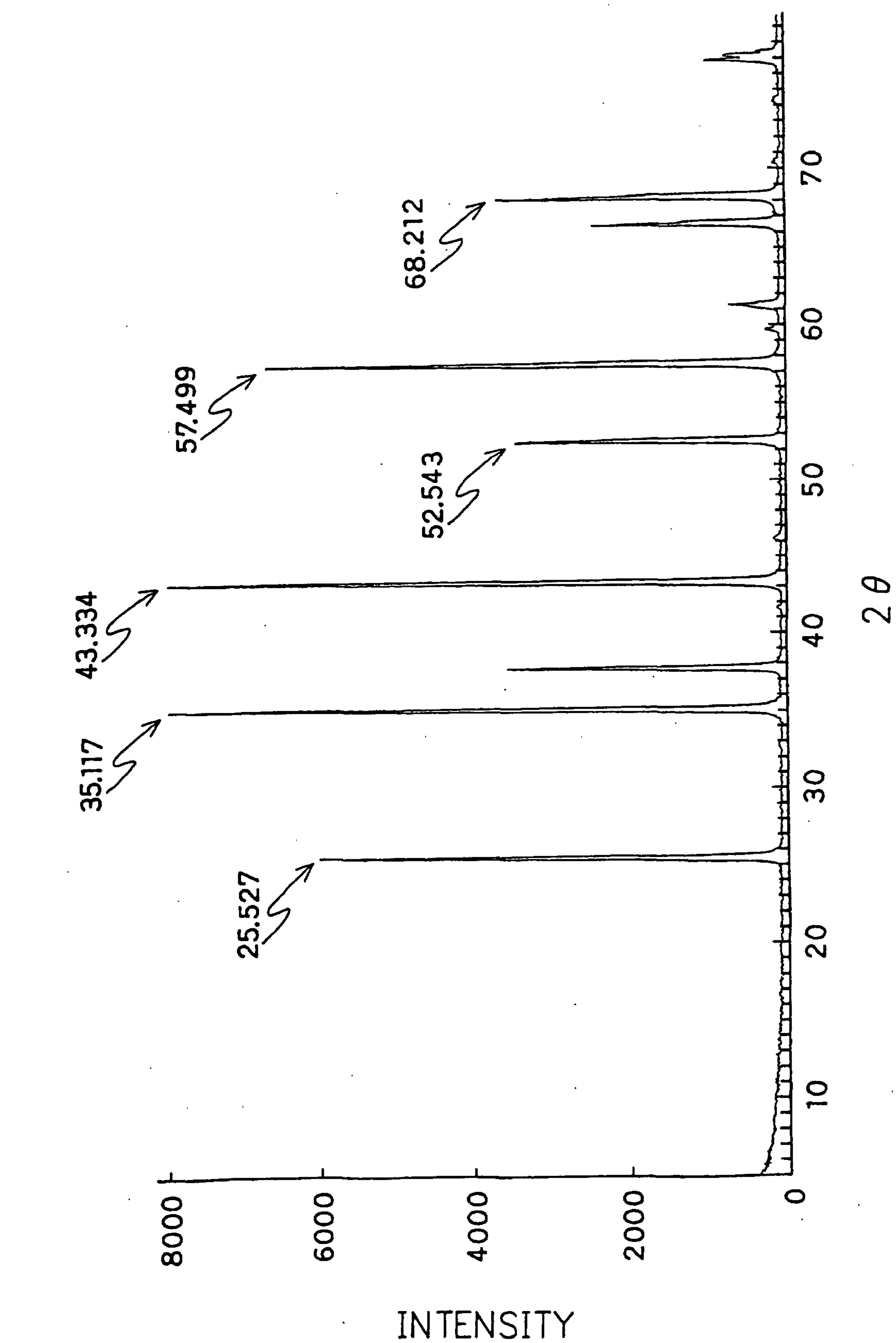
25.527
35.117
43.334
57.499
52.543
68.212
8000
6000
4000
2000
0
10
20
30
40
50
60
70
INTENSITY
2θ

## INTERNATIONAL SEARCH REPORT

International application No.
PCT/JP02/13047

A. CLASSIFICATION OF SUBJECT MATTER
Int.Cl[7] C08L27/12

According to International Patent Classification (IPC) or to both national classification and IPC

B. FIELDS SEARCHED

Minimum documentation searched (classification system followed by classification symbols)
Int.Cl[7] C08L27/12-27/20

Documentation searched other than minimum documentation to the extent that such documents are included in the fields searched

Electronic data base consulted during the international search (name of data base and, where practicable, search terms used)
WPIL Derwent

C. DOCUMENTS CONSIDERED TO BE RELEVANT

| Category* | Citation of document, with indication, where appropriate, of the relevant passages | Relevant to claim No. |
|---|---|---|
| A | JP 2000-290454 A (Nippon Mektron, Ltd.), 17 October, 2000 (17.10.00), Full text (Family: none) | 1-18 |
| A | JP 2000-154369 A (Kabushiki Kaisha Morisei Kako), 06 June, 2000 (06.06.00), Full text (Family: none) | 1-18 |
| A | JP 9-31283 A (Nippon Mektron, Ltd.), 04 February, 1997 (04.02.97), Full text & US 5637648 A | 1-18 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 March, 2003 (18.03.03) | 01 April, 2003 (01.04.03) |
| Name and mailing address of the ISA/ Japanese Patent Office | Authorized officer |
| Facsimile No. | Telephone No. |

Form PCT/ISA/210 (second sheet) (July 1998)

## INTERNATIONAL SEARCH REPORT

International application No.
PCT/JP02/13047

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-502122 A (E.I. Du Pont de Nemours & Co.), 22 February, 2000 (22.02.00), Full text & WO 97/19983 A1 | 1-18 |
| A | WO 01/32782 A1 (Daikin Industries, Ltd.), 10 May, 2001 (10.05.01), Full text & EP 1253172 A1 | 1-18 |

Form PCT/ISA/210 (continuation of second sheet) (July 1998)